# EUROPEAN PATENT APPLICATION

(11) **EP 4 734 363 A1**
(43) Date of publication of application: **29.04.2026**
(21) Application number: 25210674.5
(22) Date of filing: 23.10.2025
(51) Int. Cl.: H03F 1/32, H03F 3/189, H03F 3/20

(54) **AMPLIFIER DEVICE WITH ANALOG AND DIGITAL PREDISTORTION**

(30) Priority: 28.10.2024 NL 2038935
(71) Applicant: Prodrive Technologies Innovation Services B.V., 5692 EM Son en Breugel (NL)
(72) Inventor: VAN ARK, Bart, Son en Breugel (NL)
(74) Representative: Arnold & Siedsma

(57) **Abstract**

An amplifier device (10) comprises a signal input (11) configured to receive an analog signal, a signal output (12) and a main signal path (13) between the signal input and the signal output. Amplifier circuitry (14) is arranged in the main signal path. The amplifier device further comprises signal predistortion circuitry (15). The signal predistortion circuitry comprises analog predistortion circuitry (151) configured to generate a first predistortion signal and digital predistortion circuitry (152) configured to generate a second predistortion signal. The signal predistortion circuitry is configured to adapt a signal in the main signal path based on the first predistortion signal and on the second predistortion signal for at least partially compensating a non-linearity of the amplifier circuitry. The analog predistortion circuitry (151) and the digital predistortion circuitry (152) are arranged in parallel signal paths.

## Description

### Technical field

The present disclosure is related to amplifier systems, particularly to power amplifier systems such as radio frequency (RF) power amplifier systems.

### Background art

Power amplifiers, such as RF amplifiers, are used in a wide variety of applications including, but not limited to, magnetic resonance imaging (MRI) and semiconductor plasma processing. In these applications, power amplifiers need to have very linear and stable performance in terms of both power and phase. Such specifications cannot be achieved by the power amplifier itself, since a higher efficiency comes at a cost of deteriorated linearity. In MRI applications, generally used Class-AB, B or C amplifiers have reasonable efficiency, but gain compression, memory effects and thermal drift distort the output signal resulting in a deteriorated image quality.

It is known to linearize the output of an amplifier through predistortion, which is a feed-forward kind of distortion compensation. Predistortion can be implemented in circuitry either in the analog domain, or in the digital domain. One advantage of digital predistortion (DPD) circuitry is that the non-linearity of the amplifier can be compensated with high accuracy based on a higher order degree polynomial or look-up-table (LUT), providing high linearity results over a large gain range and flexibility of implementation. One disadvantage of the digital implementation is that domain conversions and digital computations introduce a signal delay, which has to be compensated. This is less important if the amplifier circuitry is fed with a digital input signal, since the digital signal can be directly applied in the DPD circuitry.

An analog predistortion (APD) circuitry typically comprises a detector configured to convert the input signal amplitude to a representative voltage, which is coupled to a scaling circuitry that drives a variable gain amplifier to adapt the signal that is input to the amplifier. One advantage of the analog implementation is its speed, which, if designed with a proper input signal tracking, makes the predistortion compensation almost instant. One disadvantage of the analog implementation is that the scaling circuitry typically provides a simple compensation, which doesn't include higher order compensation terms, such as higher order polynomial terms. As a result, the higher order non-linearity of the power amplifier cannot be tracked properly which may not provide accurate linearity over the entire gain range of the amplifier.

US 8779851 discloses a circuit for linearizing the output of a power amplifier. The circuit includes a main signal path from a digital signal input to a power amplifier and a digital predistorter and an analog predistorter disposed outside of the main signal path for predistorting the main signal. The circuit further includes high order and low order distortion determiners. The predistortion is divided into higher order distortion signals, further away from the main signal, and lower order distortion signals, closer to the main signal. The lower order distortion signals are generated by the digital predistorter and are then added to the main signal in the main signal path prior to a frequency up-converter, via a first switch. Based on the higher order distortion signals, coefficients are determined and sent to analog predistorter. The output of analog predistorter is added to the main signal path, prior to the power amplifier, via a second switch.

US 2023/0421120 discloses another power amplifier circuit with a digital signal input, an analog predistortion circuitry an a digital predistortion circuitry for linearizing the output of the amplifier. The analog predistortion circuitry includes a varactor having an output coupled to the signal input of the amplifier and a tuning input. A push varactor bias circuitry is configured to adjust bias voltage at the tuning input of the varactor in response to a distortion compensation signal received at a bias control input and thereby adjust capacitance at the signal input and reduce signal distortion at the output of the amplifier. The digital predistortion circuitry receives an RF signal at the digital signal input and outputs a predistorted RF signal at an RF analog output that is coupled to the signal input of the amplifier and to the input coupler/detector of the push varactor bias circuitry (analog predistortion circuitry).

In the circuits of US 8779851 and US 2023/0421120, the digital predistortion circuitry and the analog predistortion circuitry are arranged in series along the main signal path, and both circuits are configured to work with a digital signal input. Since the input signal is in the digital domain, the digital predistortion can be generated with insignificant time delay compared to the main signal. This is however not possible when the input signal of the amplifier circuitry is in the analog domain. This is especially the case for applications such as MRI and broadcast applications when the input signal generator is remote from the amplifier.

### Summary

It is an object of the present disclosure to provide systems and methods allowing to linearize the output of an amplifier, particularly a power amplifier, with high accuracy when the signal to be amplified is available in the analog domain. It is an object to provide such systems and methods which are easier to implement, have a smaller footprint and/or provide improved linearity, speed, or balance of linearity and speed.

According to a first aspect of the present disclosure, there is therefore provided an amplifier device, as set out in the appended claims. An amplifier device according to the present disclosure comprises a signal input, a signal output, a main signal path between the signal input and the signal output and amplifier circuitry arranged in the main signal path and comprising an amplifier input and an amplifier output coupled to the signal output. The signal input is configured to receive an analog signal. The amplifier device further comprises signal predistortion circuitry comprising analog predistortion circuitry and digital predistortion circuitry. The analog predistortion circuitry is configured to generate a first predistortion signal for the analog signal in an analog predistortion signal path. The digital predistortion circuitry is configured to generate a second predistortion signal for the analog signal in a digital predistortion signal path. The signal predistortion circuitry is further configured to adapt a signal in the main signal path based on the first predistortion signal and the second predistortion signal for at least partially compensating a non-linearity of the amplifier circuitry. The analog and digital predistortion signal paths are arranged as parallel signal paths, such as between the analog signal input and the amplifier input and are advantageously parallel to the main signal path.

One benefit of arranging the analog predistortion circuitry and the digital predistortion circuitry in parallel signal paths is that both can operate in a complementary fashion for an analog signal to be amplified. As a result, the analog predistortion circuitry acts fast and particularly counteracts the lower order non-linear gain characteristics inherent to the amplifier circuitry. After a short time delay inherent to the digital predistortion circuitry, the digital predistortion circuitry acts to counteract particularly the higher order non-linear gain characteristics to obtain an accurate tuning for analog input signals. Hence the speed of the analog predistortion circuitry and the accuracy of the digital predistortion circuitry can be combined to obtain fast and accurate non-linearity distortion compensation for analog input signals. Such a signal predistortion circuitry ensures that the total gain at the amplifier output remains consistent, regardless of power output variations. This stability in total gain allows for a constant loop response, which can further be adjusted to maintain a consistent output quality across all power levels.

Advantageously, the signal predistortion circuitry further comprises signal combining circuitry configured to generate a third predistortion signal from combining the first predistortion signal and the second predistortion signal. The first and second predistortion signals can be combined by addition or multiplication. The predistortion signals of the analog predistortion circuitry and the digital predistortion circuitry are hence advantageously combined to a single predistortion signal that is utilized to adapt the signal of the main signal path, which is to be amplified, in a single adaptation step, e.g. by addition, multiplication or by scaling, such as through a variable gain amplifier. This reduces system footprint and complexity.

Advantageously, the analog predistortion signal is configured to receive the analog signal at a first frequency, e.g. radio frequency, to generate the first predistortion signal, whereas the digital predistortion circuitry is configured to receive the analog signal at a second frequency lower than the first frequency, e.g. baseband or intermediate frequency, such as following a frequency down-conversion of the analog signal, to generate the second predistortion signal. One advantage is that costly analog to digital converters can be avoided while the analog predistortion circuitry is simplified because the high frequency filters are easier to implement than if the analog signal would be processed at baseband or intermediate frequency. In addition, or alternatively, the main signal path comprises a signal splitter configured to split the analog signal in quadrature components, i.e. which have a quadrature phase relation. The signal predistortion circuitry advantageously comprises a component input for each of the quadrature components, which is coupled to the digital predistortion circuitry. The component inputs can be coupled to the analog predistortion circuitry. Alternatively, the analog predistortion circuitry can have an input coupled to the main signal path upstream of (e.g., at an input of) the signal splitter. The signal splitter and the frequency down-converter can be combined into a single quadrature down-converter. Advantageously, the main signal path is free from digital signal processing circuitry between the signal input and the amplifier input.

According to a second aspect, there is provided an apparatus including the amplifier device, as set out in the appended claims. The apparatus can comprise one or more antennas, such as one or more magnetic coils that are driven by the amplifier device of the present disclosure.

According to a third aspect, there is provided a method of linearizing an output of an amplifier device, as set out in the appended claims. An amplifier device according to the present disclosure advantageously comprises a signal input configured to receive an analog signal, a signal output, amplifier circuitry arranged between the signal input and the signal output, and analog predistortion circuitry and digital predistortion circuitry. The amplifier device advantageously implements the method according to the third aspect.

### Brief description of the drawings

Aspects of the present disclosure will now be described in more detail with reference to the appended drawings, wherein same reference numerals illustrate same features and wherein:
Figure 1 represents a diagram of an amplifier device according to aspects of the present disclosure;

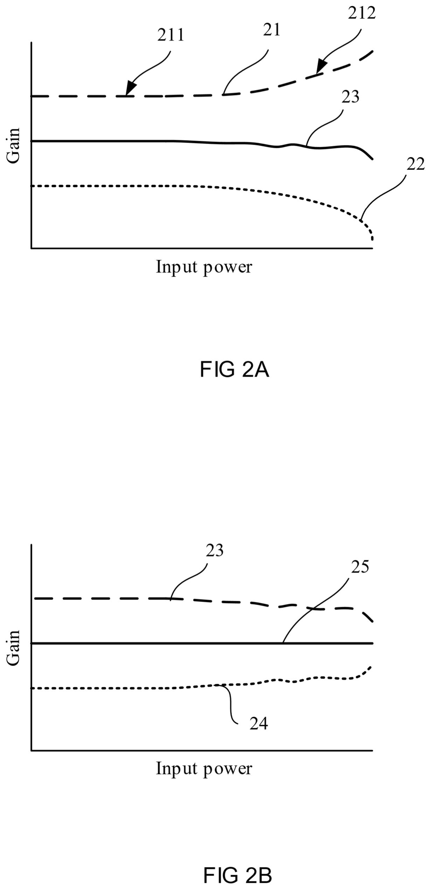

Figure 2A represents a graphic of the gain curve of the power amplifier as a function of input power without predistortion (curve 21), a distortion compensation curve generated by analog predistortion circuitry (curve 22) and a compensated gain curve of the power amplifier (curve 23) when compensated with analog predistortion only; Figure 2B represents a graphic of the gain curve of the power amplifier as a function of input power when compensated with analog predistortion only (curve 23), a distortion compensation curve generated by digital predistortion circuitry (curve 24) for compensating a residual distortion of the gain curve 23, and a compensated gain curve of the power amplifier (curve 25) when compensated with analog predistortion and digital predistortion;

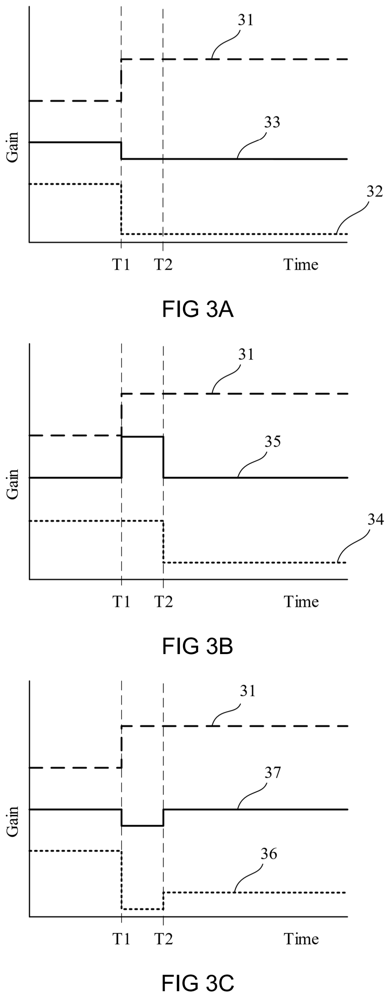

Figure 3A represents a graphic of the power amplifier gain when a step from minimum to maximum power is applied to the power amplifier at time instant T1 (curve 31), the gain compensation by an analog predistortion circuit (curve 32) and the resulting compensated power amplifier gain (curve 33); Figure 3B represents a graphic of the power amplifier gain when a step from minimum to maximum power is applied to the power amplifier at time instant T1 (curve 31), the gain compensation by a digital predistortion circuit (curve 34) and the resulting compensated power amplifier gain (curve 35); Figure 3C represents a graphic of the power amplifier gain when a step from minimum to maximum power is applied to the power amplifier at time instant T1 (curve 31), the gain compensation by combined analog and digital predistortion circuitry according to the present disclosure (curve 36) and the resulting compensated power amplifier gain (curve 37);
Figure 4 represents a flowchart of a method of linearizing the output of a power amplifier according to the present disclosure;
Figure 5 represents an alternative diagram of an amplifier device according to aspects of the present disclosure;
Figure 6 represents the diagram of Fig. 1 with a Cartesian feedback control loop;
Figure 7 represents yet an alternative diagram of an amplifier device according to aspects of the present disclosure;
Figure 8 represents another alternative diagram of an amplifier device according to aspects of the present disclosure;
Figure 9 represents a flowchart of a method of linearizing the output of a power amplifier as implemented by the diagram of Fig. 8;
Figure 10 represents a diagram of an amplifier device according to aspects of the present disclosure including a feed-forward signal path.
Figure 11 represents yet another alternative diagram of an amplifier device according to aspects of the present disclosure, in which the predistortion circuitry takes the control signal as an input;
Figure 12 represents a diagram of an amplifier device embodying an implementation to alternative to Fig. 11, in which the digital predistortion circuitry takes as input, the control signal prior to frequency up-converting whereas the analog predistortion circuitry takes as input, the control signal following frequency up-converting.
Figure 13 represents a diagram of an apparatus including a driving circuit for driving multiple antennas, in which the driving circuit comprises the amplifier device according to the present disclosure.

### Detailed description

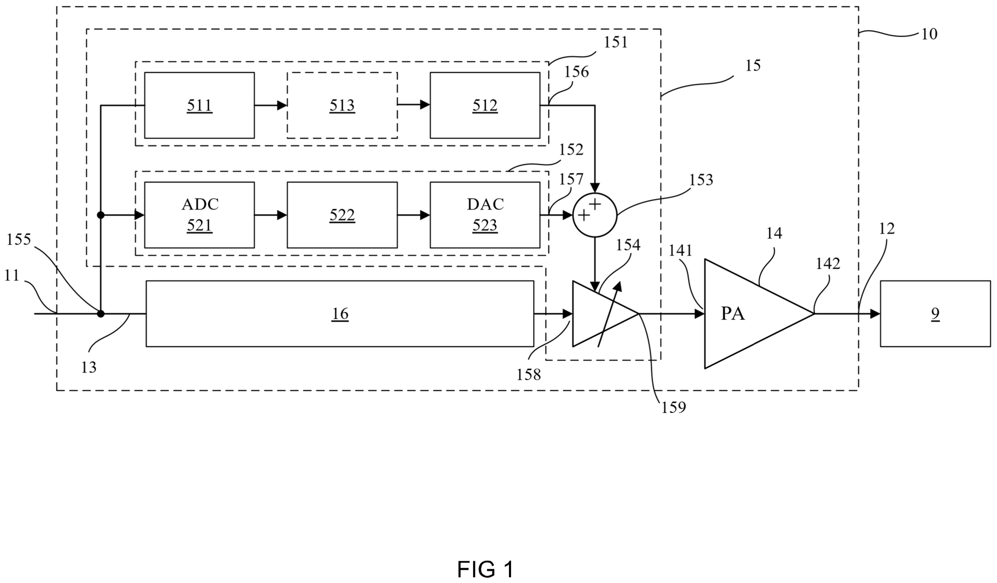

Referring to Fig. 1, an amplifier device or system 10 is configured to increase the energy level of an electrical signal provided at an input 11 of the amplifier system 10 by a factor to obtain an amplified signal and to apply the amplified signal at an output 12 of the amplifier system 10. The output 12 can be connected to a load 9, such as an antenna (e.g., a magnetic coil) of an MRI apparatus, a plasma system or a wireless communications system. The amplified signal of output 12 is typically utilized to drive the load 9. The electrical signal is provided at the input 11 as an analog signal, which can be in a radio frequency (RF) band, an intermediate frequency (IF) band, or which can be a baseband signal. The amplified signal at the output 12 is in the analog domain and is typically at radio frequency. Suitable radio frequency bands are between 3 MHz and 10 GHz, specifically between 30 MHz and 1 GHz.

The amplifier system 10 comprises a main signal path 13 from the input 11 to the output 12. A power amplifier (PA) 14, which is basically configured to increase the energy level of (i.e., to amplify) the electrical signal, is arranged in the main signal path 13. The power amplifier 14 comprises an amplifier input 141 configured to receive an analog signal and an amplifier output 142 coupled to the output 12. The amplifier system 10 can further comprise signal control circuitry 16 arranged in the main signal path, between the input 12 and the amplifier input 141. Signal control circuitry 16 is advantageously configured to control and adjust the electrical signal appearing at the amplifier output 142. In some examples, the signal control circuitry can comprise a closed loop control circuitry, including a feedback signal path, as will be described further below.

The amplifier system 10 further comprises signal predistortion circuitry 15 having an input 155 coupled to the input 11 of the amplifier system 10. The input 155 is configured to receive an analog signal, specifically the signal applied at input 11. Signal predistortion circuitry 15 is configured to generate a predistortion signal for the analog signal applied at the input 155 (input 11) and to adapt the signal applied at the amplifier input 141 based on the predistortion signal for at least partially compensating a non-linearity of the amplifier 14. To this end, signal predistortion circuitry 15 comprises analog predistortion (APD) circuitry 151 and digital predistortion (DPD) circuitry 152 arranged in parallel signal paths. In the present example, both the APD circuitry 151 and the DPD circuitry 152 receive a same signal as input, i.e. the analog signal applied at the input 155 forms the input to both analog and digital predistortion circuitries.

APD circuitry 151 is configured to process the signal from input 155 entirely in the analog domain to generate an analog predistortion signal at an output 156. DPD circuitry 152 is configured to process the signal from input 155 in the digital domain to generate a digital predistortion signal, which is digital-to-analog converted and provided as an analog predistortion signal at the output 157 of the DPD circuitry 152. The output 156 of APD circuitry 151 and the output 157 of DPD circuitry 152 are combined in a combining circuitry 153, e.g. a summing circuitry, to obtain a combined predistortion signal advantageously being a sum of the predistortion signal generated by the APD circuitry 151 and the predistortion signal generated by the DPD circuitry 152.

The combined predistortion signal is fed to a variable gain amplifier (VGA) 154 which is arranged in the main signal path 13. VGA 154 comprises a signal input 158 coupled to the input 11 and a signal output 159 coupled to the amplifier input 141. The combined predistortion signal determines the (tuneable) gain applied by the VGA 154 to the (analog) signal applied at signal input 158, and hence forms a predistortion factor which at least in part compensates non-linearities of the power amplifier 14.

The analog predistortion circuitry 151 can comprise a signal detector 511, such as a log detector, a linear detector or a mixer, to detect an amplitude of the signal at input 155 and convert it to a representative voltage. Signal detector 511 is coupled to a scaling circuit 512 which applies a (variable) scaling factor representative of the predistortion to be applied, to obtain the predistortion signal at output 156. The scaling factor is advantageously variable and dependent on the amplitude of the signal detected by detector 511. Optional filtering circuit 513 can be provided to improve transient behaviour and/or to filter out undesired components.

The scaling circuit 512 typically applies a lower order distortion compensation and may not be capable of compensating higher order distortion effects of the power amplifier 14. However, since APD circuitry 151 is processing entirely in the analog domain, it can operate at high speed and therefore it can apply a predistortion in substantial synchronism with the input signal (i.e., with no substantial time delays).

The digital predistortion circuitry 152 can comprise an analog-to-digital converter (ADC) 521 coupled to the input 155 and configured to convert the analog signal at input 155 to the digital domain. ADC 521 is coupled to a digital signal processing circuitry 522 which is implemented with distortion compensation logic and configured to generate a digital predistortion signal that is fed to digital-to-analog converter (DAC) 523 for converting the digital predistortion signal to the analog domain at output 157. Digital signal processing circuitry 522 can comprise a look-up table (LUT) or alternatively be implemented with higher order coefficients (e.g., polynomial coefficients) for distortion compensation, such as in a micro-processing unit, e.g. an application specific integrated circuit (ASIC) or a field-programmable gate array (FPGA).

It will be appreciated that the APD circuitry 151 and the DPD circuitry 152 advantageously work in a complementary fashion. That is, while APD circuitry 151 is configured to compensate lower order distortion effects of the power amplifier 14, the DPD circuitry 152 is configured to compensate primarily higher order distortion effects of the power amplifier 14. As a result, the combined predistortion signal obtained at combining circuit 153 is capable of compensating both lower order and higher order distortion effects of the power amplifier in a single signal adaptation step at VGA 154. Advantageously, the DPD circuitry 152 is configured to apply a predistortion to only compensate residual distortion effects remaining from analog predistortion compensation, i.e. distortion effects that are not, or not entirely compensated by the APD circuitry 151. This can be obtained by proper implementation of the digital signal processing circuitry 522, e.g. by determining the non-linearity distortion of the amplifier system 10 when the APD circuitry 151 is operational but the DPD circuitry 152 is not operational.

The operation principle of the signal predistortion circuitry 15 is now illustrated in relation to Figs. 2A, 2B and 3. Referring to Fig. 2A, the power amplifier 14 has a gain curve 21 which has non-linear behaviour as a function of the input power. Particularly, the gain curve 21 typically includes a linear region 211 at lower power levels, in which the power amplifier gain has a linear relation, e.g. is constant, as a function of input power, and a non-linear region 212 at higher power levels. The APD circuitry 151 is therefore configured to generate an appropriate scaling factor for compensating the non-linearity distortion of curve 21. This scaling factor can be variable as a function of the input power (e.g., the amplitude of the signal at input 155), as illustrated by the curve 22. Applying the predistortion signal from APD circuitry 151 (as made available at output 156) to the VGA 154 results in a compensated gain curve 23 of the power amplifier. It can be seen that the compensated gain curve 23 based on solely APD compensation will still include a residual non-linearity distortion in power amplifier gain, particularly at higher input power levels. Referring to Fig. 2B, the DPD circuitry 152 is therefore configured to compensate the residual distortion of curve 23 (same as in Fig. 2A) by generating a supplemental predistortion signal, as illustrated by curve 24. The combined predistortion signal of curves 22 (APD) and 24 (DPD) allows for substantially completely compensating the non-linearity distortion of curve 21, to obtain gain curve 25 for the power amplifier and VGA combined.

The largest benefit of the combined APD and DPD compensation according to the present disclosure can further be seen in the time response. The APD circuitry acts very fast to pre-compensate the gain distortion nearly instantaneously, whereas the DPD circuitry for an analog input signal typically has a significant delay due to the processing time of the digital processing circuitry 521-523. This effect is illustrated in the time response of Figs. 3A-3C for a power step applied to the power amplifier at time instant T1 from minimum to maximum power. Due to the non-linearity of the power amplifier, a power step applied to the power amplifier at T1 will distort its (uncompensated) gain, as illustrated by curve 31. Referring to Fig. 3A, curve 32 illustrates a typical output of an APD circuit, which acts to compensate the gain distortion instantaneously at time instant T1. The resulting gain if only APD would be applied is illustrated by curve 33. At higher power levels, the APD will typically not be capable to compensate higher order non-linearity distortion effects of the power amplifier, resulting in a slightly reduced gain starting at time instant T1. Referring to Fig. 3B, curve 34 illustrates a typical output of a DPD circuit if no APD would be applied in relation to a same curve 31 of the power amplifier. Due to the signal processing delay the DPD circuit responds to the power step of time instant T1 only at a later time instant T2, hence with a time delay T2-T1. An important effect is that in the delay time interval between T1 and T2 the compensated power amplifier output will exhibit a high gain transient as illustrated by curve 35, which can result in overshoot and instability, particularly if the power amplifier is arranged in a closed loop control system.

Referring to Fig. 3C, curve 36 illustrates the output of a combined APD and DPD circuit according to the present disclosure. In curve 36, the instant action of the APD circuitry at time instant T1 can be seen, as well as the compensation by the DPD circuitry at time instant T2. The compensated power amplifier output will exhibit a gain as illustrated by curve 37. It can be seen that the high gain transient of curve 35 is eliminated. During the DPD time delay interval (between time instants T1 and T2), the combined VGA and power amplifier gain is advantageously slightly smaller than the power amplifier gain in the linear region (i.e., at low power levels) to prevent overshoot, as illustrated by the dip in curve 37 in the time interval T1-T2. To this end, the predistortion signal generated by the APD circuitry for compensating the gain distortion of the power amplifier is advantageously selected such that the APD compensated gain of the power amplifier is always smaller than the power amplifier gain in the linear region.

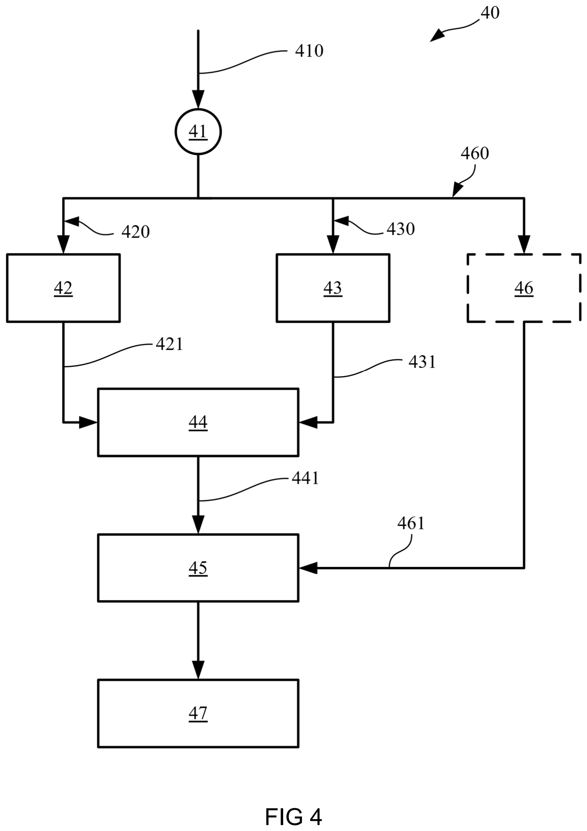

Referring to Fig. 4, a method 40 implemented in the amplifier system 10 for linearizing the output 12 (amplifier output 142) comprises an operation 41 of applying an analog signal 410 to be amplified by a power amplifier, e.g. at input 11 or 155. In operation 42, an APD predistortion signal 421 is generated for the analog signal 410 in an APD signal path 420, such as by APD circuitry 151. In operation 43, a DPD predistortion signal 431 is generated for the analog signal 410 in a DPD signal path 430, such as by DPD circuitry 152. In a main signal path 460 of the amplifier system, the analog signal 410 is optionally controlled and/or adjusted in operation 46. Operation 46 can comprise one or more operations of frequency down-converting, quadrature splitting (i.e., dividing an input signal into two signals which are in quadrature phase relation), filtering, frequency up-converting and quadrature combining (i.e., combining two signals having quadrature phase relation into a single output signal). In operation 46, advantageously, the analog signal 410 is processed entirely in the analog domain. This avoids unnecessary time delays. Operations 42 and 43, and optionally 46, advantageously run in parallel signal paths 420, 430 and 460 respectively. It will be appreciated that the operations 42 (APD) and 43 (DPD) are performed independently of one another, i.e., the respective outputs of operations 42 and 43 are function of the analog input signal 410 and are not affected by the outcome (output) of the other one of operations 42 and 43. The APD signal 421 and the DPD signal 431 are combined, e.g. added or multiplied, in operation 44, such as by combining circuitry 153 to obtain a combined predistortion signal 441. In operation 45, an analog signal 461, representative of the analog signal 410, e.g. as generated through operation 46, is adapted based on the combined predistortion signal 441 for at least partially compensating a non-linearity of the power amplifier, e.g. by VGA 154. In operation 47, the adapted signal obtained in operation 45 is fed to the power amplifier for amplification.

It will be appreciated that the operations 44 and 45 can be combined or integrated in a single operation. In some examples, the analog signal 461 can be sequentially adapted based on the APD signal 421 and the DPD signal 431, e.g. in consecutive combining circuits, such as multiplier circuits or variable gain amplifiers.

To calibrate the APD circuitry 151 and the DPD circuitry 152, at first, the amplifier system is run with DPD signal path 430 turned off. The scaling factor of the APD circuitry 151 can be determined such that the total gain of the power amplifier and VGA is smaller or equal to the gain of the power amplifier extrapolated from the linear region 211 (Fig. 2A) for all power levels. Next, the amplifier system is run with both APD signal path 420 and DPD signal path 430 turned on. The parameters of the digital processing circuitry 522 can be determined so as to compensate for the residual distortion.

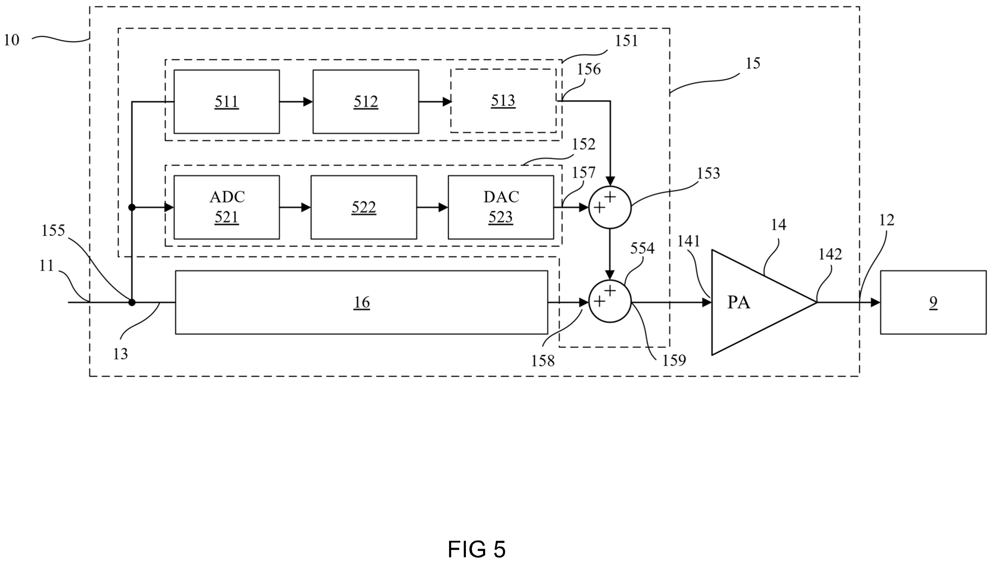

Referring to Fig. 5, in an alternative implementation, the amplifier system 10 of Fig. 1 is modified only in that the VGA 154 is replaced by a combining circuit 554 which combines the signal from the main signal path at input 158 and the combined predistortion signal from combining circuit 153 into a distortion compensated signal by addition, which is made available at the output 159. Hence, in the example of Fig. 5, the combined predistortion signal is a signal that is added to the signal of the main signal path 13 to compensate for non-linear distortion of the power amplifier, rather than a signal that determines a tuneable gain of the signal of the main signal path as in Fig. 1. It is alternatively possible to replace the VGA 154 by a combining circuit that multiplies the signal from the main signal path with the combined predistortion signal from combining circuit 153. Yet alternatively, it is possible to connect the outputs 156 and 157 of the APD and DPD circuitries directly to a combining circuit in the main signal path 13, hence dispensing with combining circuit 153.

The signal control circuitry 16 can be any suitable circuitry configured to condition the signal applied at the input 11 prior to amplification by the power amplifier 14. The signal control circuitry 16 can comprise a closed loop control circuitry, particularly a Cartesian feedback control loop, in which the baseband signal information is processed in Cartesian form, including an in-phase signal path (I) and a quadrature signal path (Q). Alternatively, or in addition, the signal control circuitry 16 can be arranged to process the signal in the main signal path at least in part at baseband frequency or intermediate frequency. To this end, the signal control circuitry 16 can comprise a frequency down-converter having an input coupled to the input 11 and a frequency up-converter having an output coupled to the amplifier input 141, or the VGA input 158.

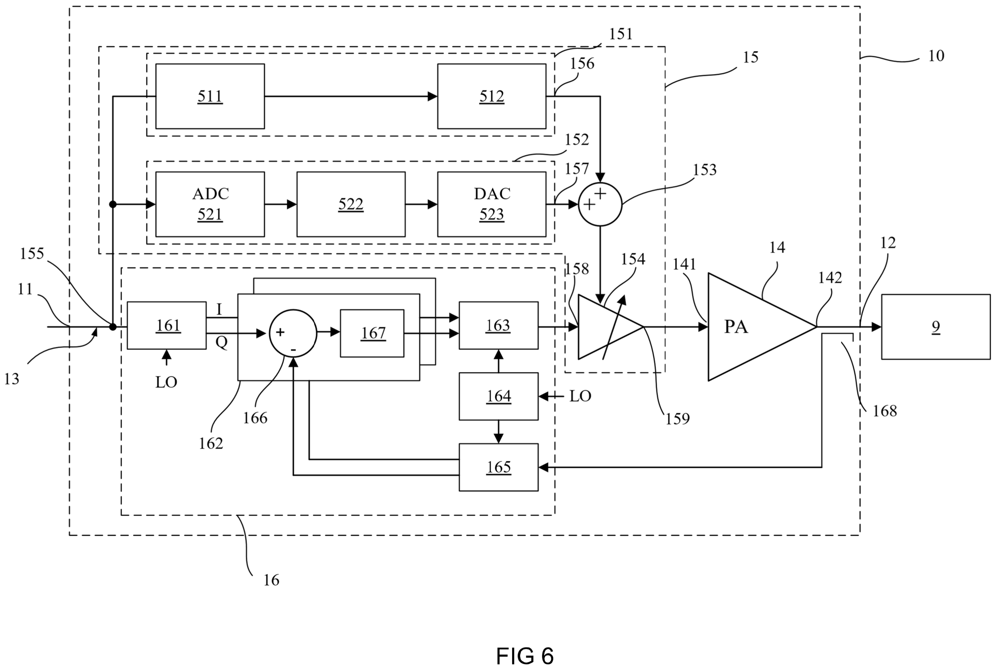

Referring to Fig. 6, in a typical Cartesian feedback control loop, the signal control circuitry 16 can comprise a signal splitter, configured to split the input signal applied at input 11 in quadrature components, which have a quadrature phase relationship and which are processed in individual signal paths I and Q. If the input signal is of radio frequency, a frequency down-converter is typically added to down-convert the RF input signal to baseband or intermediate frequency. The quadrature down-converter 161 is a frequency down-converter combining frequency down-converting and signal splitting. The input signal applied at input 11 is hence converted from radio frequency to quadrature components of baseband or intermediate frequency. Each of the signal paths I and Q comprise individual feedback control loops 162 configured to generate and process respective error signals. The error signals are generated in a subtractor 166 and fed to respective loop filters 167. The loop filter 167 can comprise a polyphase filter or any other suitable filter for conditioning the error signal. A quadrature up-converter 163 has inputs respectively coupled to the outputs of the feedback control loops 162 of the I and Q signal paths. The quadrature up-converter 163 is configured to convert the in-phase and quadrature signals of intermediate or baseband frequency to a complex signal of radio frequency. The output of the quadrature up-converter 163 is connected to the input 158 of variable gain amplifier 154 or other combining circuit 554 as described above.

A (directional) coupler 168 is configured to sample the output of the power amplifier 14 and to attenuate it to a suitable level for applying it to a quadrature down-converter 165. A phase shifter 164 is supplied with local oscillator signals LO and configured to generate phase-shifted signals between the quadrature up-converter 163 and the quadrature down-converter 165 so as to ensure that the up-conversion and down-conversion processes are coherent. The outputs of the quadrature down-converter 165 are fed to the subtractors 166 of the respective I and Q signal paths, hence generating the respective error signal. One advantage of the orthogonal nature of the Cartesian feedback system is that the I and Q signal paths can operate completely independently.

It will be appreciated that the signal control circuitry 16, between input 155 to signal predistortion circuitry 15 and the power amplifier 14 is advantageously completely operating in the analog domain to avoid signal delays that may negatively affect the operation of signal predistortion circuitry 15. The input 155 to signal predistortion circuitry 15 can be arranged upstream of the signal control circuitry 16, such as at the input side of a signal splitter or quadrature down-converter 161, as shown in Fig. 6.

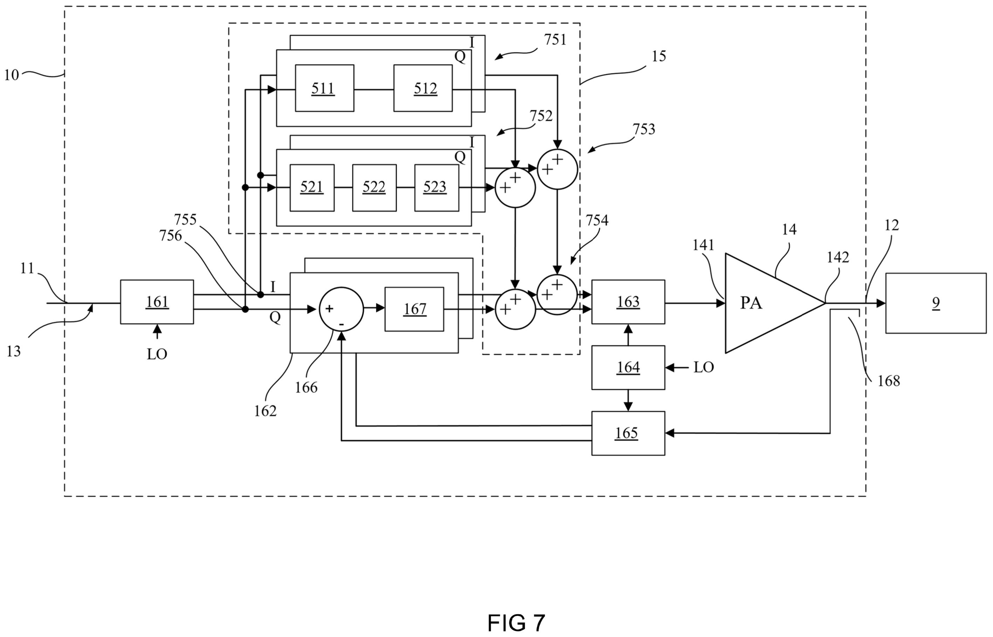

Alternatively, referring to Fig. 7, either one or both the APD circuitry 751 and the DPD circuitry 752 can have split in-phase (I) and quadrature (Q) signal paths. In such a case, the signal predistortion circuitry has in-phase input 755 and quadrature input 756. These can be arranged downstream, i.e. at the output side, of the quadrature down-converter 161, if present.

Either one or both the APD circuitry 751 and DPD circuitry 752, and possibly the summing circuitry 753 as well can be split for the in-phase and quadrature components. In some examples, the APD circuitry 751 can apply individual scaling for the in-phase and quadrature signal components, or apply a (complex) scaling factor to both signal components. The (in-phase and quadrature) outputs of the summing circuitry 753 can be utilized to adapt the signals in the respective I and Q signal paths in combining circuitry 754, particularly upstream, i.e. at the input side, of the quadrature up-converter 163.

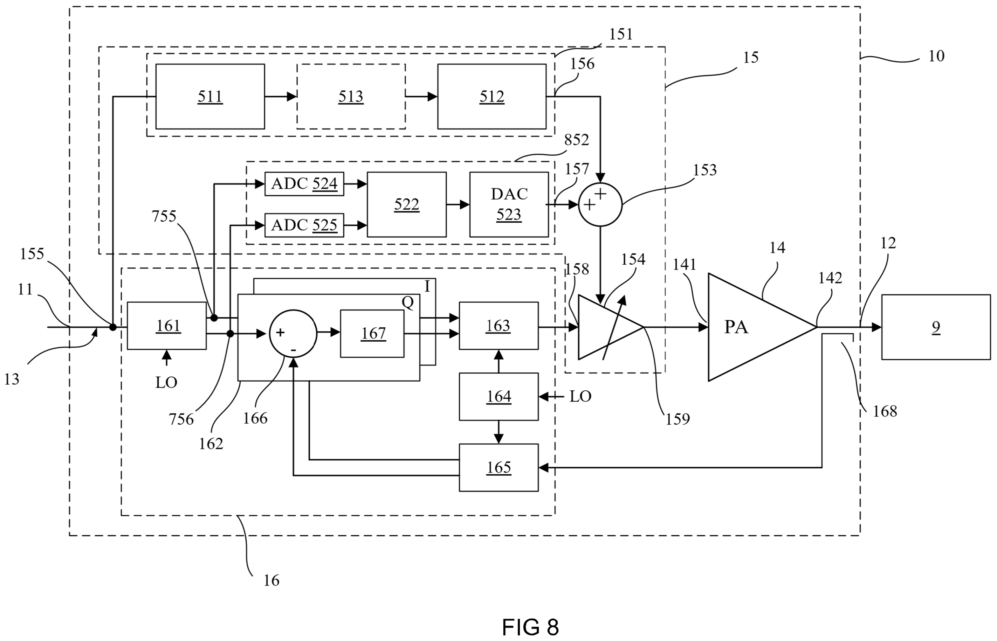

Combinations of the arrangements of Fig. 6 and Fig. 7 are possible as well. Referring to Fig. 8, the predistortion circuitry 15 comprises APD circuitry 151 analogous to the APD circuitry of Fig. 6 and DPD circuitry 852. Whereas APD circuitry 152 takes the analog signal at input 155 along the main signal path 13, the DPD circuitry takes the I and Q quadrature components of the signal at inputs 755 and 756, respectively, as inputs. DPD circuitry 852 comprises analog-to-digital converters 524 and 525 for the I and Q signal inputs, respectively. The ADCs 524 and 525 are connected to digital signal processing circuitry 522, which takes the ADC outputs as an input and generates a (single) digital predistortion signal based on both the I and Q signals of inputs 755 and 756, respectively. This can be implemented, e.g. with a look-up table. DAC 523 converts the digital predistortion signal output by digital signal processing circuitry 522 to the analog domain and makes the analog signal available at output 157. Combining circuit 153 can combine the output 156 of APD circuitry 151 and the output 157 of DPD circuitry 852 to a combined predistortion signal which defines the tuneable gain of VGA 154, as described above.

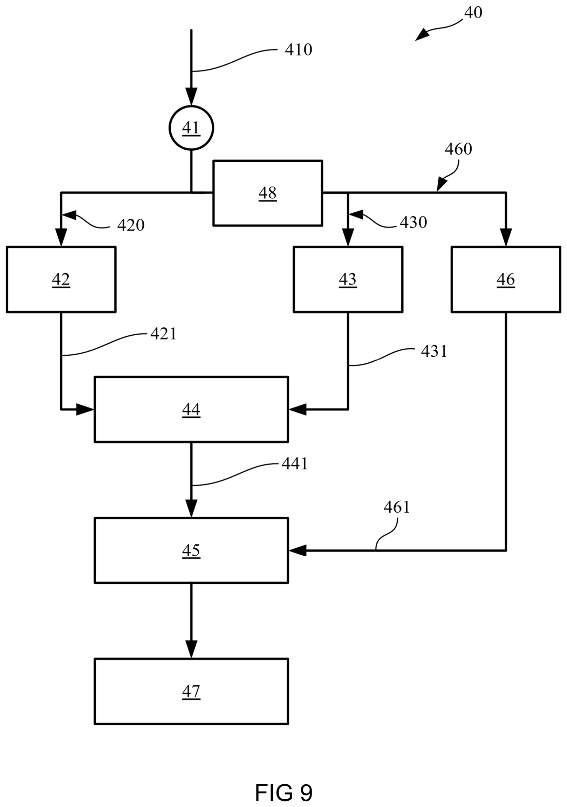

The implementation of Fig. 8 modifies the flow diagram of Fig. 4 as illustrated in Fig. 9. Operation 48 comprises quadrature splitting and/or frequency down-converting the analog signal 410. The operation 48 is applied to the signal paths 430 (DPD signal path) and 460 while not being applied to the APD signal path 420. It will be appreciated that in the present example, operation 46 will include quadrature combining and/or frequency up-converting operations.

The implementation of Figs. 8-9 has several advantages. Firstly, the APD circuitry 151 is kept simple by taking the RF signal at input 155. The signal detector circuit 511 typically includes a rectifier and associated low-pass filter which can have a higher cut-off frequency compared to the example of Fig. 7. This is advantageous because the APD circuitry can be made to operate faster to track the input signal. In addition, any filter stage 513 will be easier to implement if higher frequencies are to be filtered out. Secondly, the DPD circuitry 852 is kept simple as well by taking the intermediate or baseband I and Q signals at respective inputs 755 and 756. The ADCs 524 and 525 only need to sample the intermediate or baseband signals, such that the sampling rate can be reduced and more economical ADCs can be utilized. In addition, it becomes easier to extract signal amplitude information from the sampled signal at baseband or intermediate frequency compared to radio frequency, making implementation in the digital signal processing circuitry 522 easier.

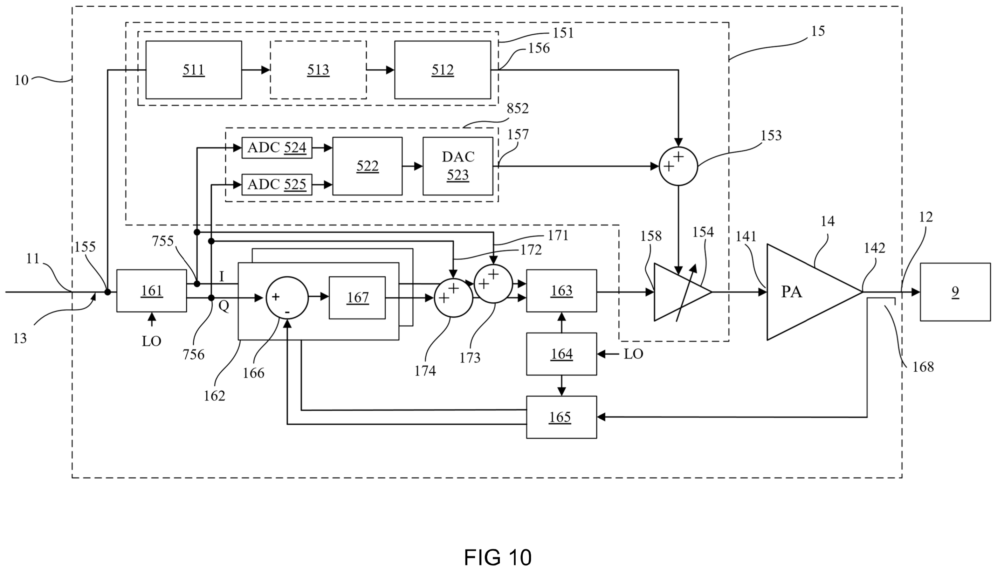

Referring to Fig. 10, the amplifier device 10 can further comprise feed-forward signal paths in addition to the APD and DPD signal paths. In some examples, feed-forward signal paths 171, 172 take the input signal, e.g. at inputs 755, 756 respectively - which may be, but need not be, inputs of the signal predistortion circuitry 15 - and feed it to signal combining circuitry 173, 174 respectively. Signal combining circuitry 173, 174 are configured to add the feed-forward signals from the feed-forward signal paths 171, 172 respectively to the control signal of the feedback control loop 162 of the respective I and Q signal path. The output of signal combining circuitry 173, 174 is fed to the quadrature up-converter 163. Feed-forward signal paths 171, 172 advantageously are configured to apply the input signal (from inputs 755, 756) without attenuation, e.g., with unity gain, and advantageously without filtering to the respective signal combining circuitry. It is alternatively possible to provide a feed-forward signal path taking the input signal upstream of the quadrature down-converter 161, e.g. at input 155, and add it to the input 158 of the variable gain amplifier 154, or alternatively to add the feed-forward signal to the amplifier input 141. Combinations of above inputs and outputs of the feed-forward signal path can be suitably made. A feed-forward signal path can improve bandwidth of the amplifier device and reduce the amplitude of perturbations of the feedback control loop, particularly when step signals of large amplitude are applied at the input 11. The feed-forward signal path as described above can be implemented in any of the amplifier device 10, i.e., in combination with any of the signal predistortion circuitry 15 according to the present disclosure.

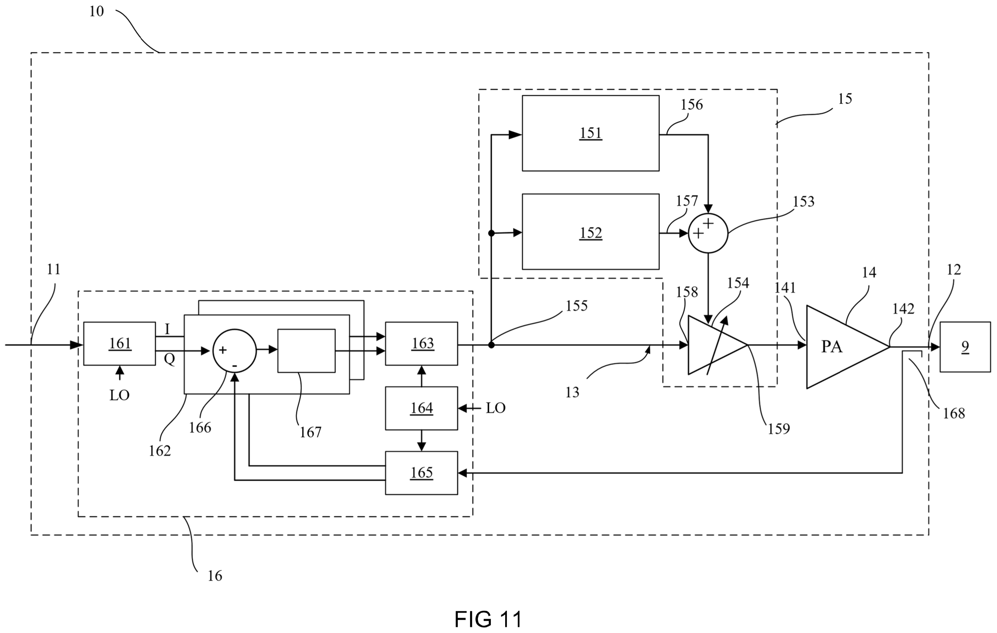

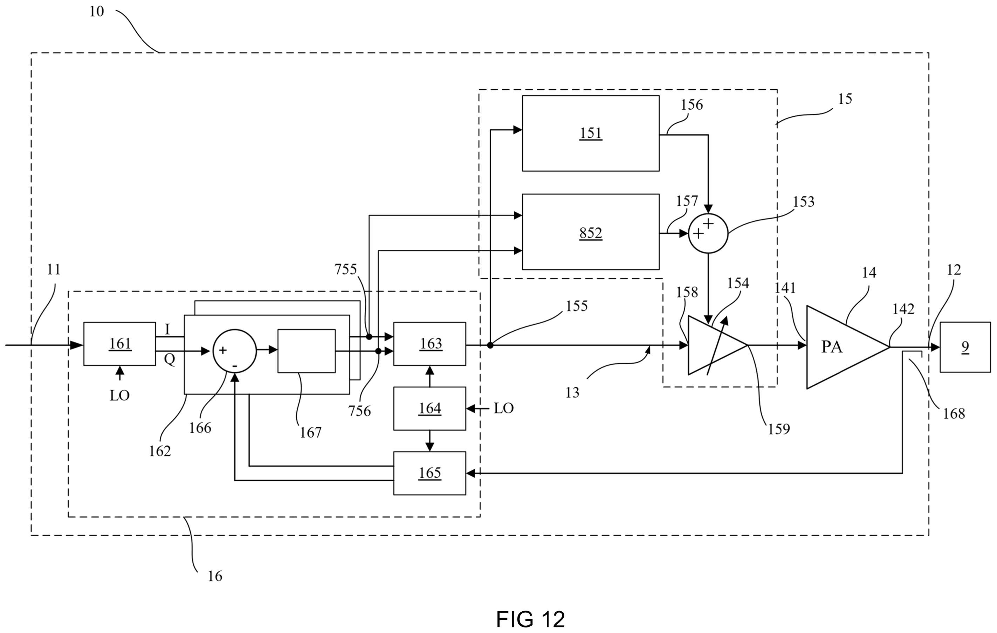

Referring to Fig. 11, in an alternative implementation, the input 155 to signal predistortion circuitry 15 can be arranged in main signal path 13 downstream of the quadrature up-converter 163, i.e. the signal control circuitry 16 is arranged upstream of the input 155. In such case, the predistortion circuitry 15 takes the control signal (i.e., the output of the signal control circuitry 16) as input. Referring to Fig. 12, the example of Fig. 11 can be modified in analogy of Fig. 8, such that the DPD circuitry 852 receives I and Q quadrature components of the (control) signal as inputs, possibly at baseband or intermediate frequency, whereas the APD circuitry 151 receives the up-converted (control) signal as input, e.g., at radio frequency. The inputs 755 and 756 to the DPD circuitry 852 are hence arranged at the input side (upstream) of the quadrature up-converter 163, advantageously at the output of the loop filter 167. The input 155 to the APD circuitry 151 is arranged at the output side (downstream) of the quadrature up-converter 163.

It will be appreciated that further combinations of the previous example configurations of the signal predistortion circuitry are possible. By way of example, the configuration of Fig. 7 can be modified in that each of the APD circuitry 751 and DPD circuitry 752 outputs a single predistortion signal and the combining circuitry 754 is arranged at the output of the quadrature up-converter 163, e.g. as is the case in Fig. 8.

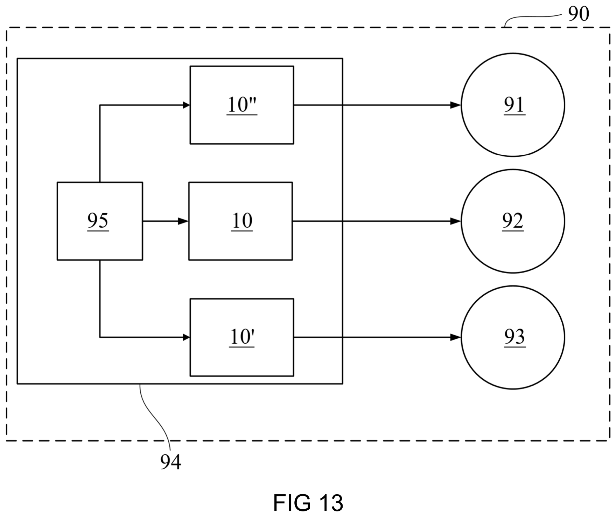

Referring to Fig. 13, an apparatus 90 can comprise one or multiple antennas, such as electromagnetic coils 91, 92, 93, coupled to a driving circuit 94. The driving circuit can comprise a control unit 95 coupled to amplifier devices 10, 10', 10", which can be any one of the amplifier devices according to the present disclosure. Amplifier devices 10, 10', 10" are coupled to a respective one of the coils 91-93. The control unit 95 is configured to generate analog driving signals for operating the coils 91-93. These driving signals are fed to the respective amplifier device 10, 10', 10" which generates amplified driving signals for the respective coil. Control unit 95 can be positioned remote from the amplifier devices 10, 10', 10". The apparatus 90 can be an MRI system in which the coils 91-93 are imaging coils, or a plasma processing system, in which the antennas are coupled to a plasma chamber for generating a plasma within the chamber.

## Claims

1. An amplifier device (10), comprising:
a signal input (11), a signal output (12) and a main signal path (13) between the signal input and the signal output,
amplifier circuitry (14) arranged in the main signal path, the amplifier circuitry comprising an amplifier output (142) coupled to the signal output (12) and an amplifier input (141),
signal predistortion circuitry (15) comprising analog predistortion circuitry (151, 751) configured to generate a first predistortion signal (421) and digital predistortion circuitry (152, 752, 852) configured to generate a second predistortion signal (431), wherein the signal predistortion circuitry is configured to adapt a first signal (461) in the main signal path based on the first predistortion signal and on the second predistortion signal for at least partially compensating a non-linearity of the amplifier circuitry (14),
**characterised in that** the signal input (11) is configured to receive an analog signal and **in that** the analog predistortion circuitry and the digital predistortion circuitry are arranged in parallel signal paths (420, 430).

2. Amplifier device of claim 1, wherein the signal predistortion circuitry (15) comprises signal combining circuitry (153, 753) configured to generate a third predistortion signal (441) from combining the first predistortion signal (421) and the second predistortion signal (431), wherein the signal predistortion circuitry further comprises signal adapting circuitry (154, 554, 754) coupled to the amplifier input (141) and configured to adapt the first signal (461) based on the third predistortion signal, preferably wherein the signal adapting circuitry comprises a variable gain amplifier (154), wherein the third predistortion signal is configured to define a variable gain applied by the variable gain amplifier to the first signal (461), wherein the variable gain amplifier has an output (159) coupled to the amplifier input (141).

3. Amplifier device of claim 2, wherein the main signal path (13) comprises a frequency up-converter (163) having an output coupled to the amplifier input (141), and wherein:
the signal adapting circuitry (154, 554) is coupled between the output of the frequency up-converter and the amplifier input, or
the signal adapting circuitry (754) is coupled to an input of the frequency up-converter.

4. Amplifier device of any one of the preceding claims, wherein the digital predistortion circuitry (152, 752, 852) comprises an analog to digital converter (521, 524, 525), digital processing circuitry (522) configured to generate a digital fourth predistortion signal and a digital to analog converter (523) configured to convert the digital fourth predistortion signal to the second predistortion signal (431).

5. Amplifier device of any one of the preceding claims, wherein the analog predistortion circuitry (151, 751) comprises a first input (155, 755, 756) coupled to the main signal path (13), generating circuitry (511) configured to generate a fifth signal representative of an amplitude of a signal at the first input, and scaling circuitry (512) configured to adapt the fifth signal by a scaling factor to obtain the first predistortion signal.

6. Amplifier device of any one of the preceding claims, wherein the digital predistortion circuitry (152, 752, 852) is configured to generate the second predistortion signal representative of a residual non-linearity of the amplifier circuitry (14) and the analog predistortion circuitry (151, 751) combined.

7. Amplifier device of any one of the preceding claims, wherein the main signal path (13) comprises a frequency down-converter (161) having an input coupled to the signal input (11), wherein the signal predistortion circuitry (15) comprises a first input (155) coupled to the main signal path between the signal input (11) and the input of the frequency down-converter (161), preferably wherein the first input (155) is coupled to one or both of: the analog predistortion circuitry (151) and the digital predistortion circuitry (152).

8. Amplifier device of any one of the claims 1 to 6, wherein the main signal path (13) comprises a frequency down-converter (161) having an input coupled to the signal input (11), wherein the signal predistortion circuitry (15) comprises a first input (155) coupled to the main signal path between the signal input (11) and the input of the frequency down-converter (161), wherein the main signal path (13) further comprises a frequency up-converter (163) having an output coupled to the amplifier input (141), wherein the signal predistortion circuitry (15) comprises a second input (755, 756) coupled to the main signal path between the frequency down-converter (161) and the frequency up-converter (163), wherein the second input is coupled to the digital predistortion circuitry (752, 852), optionally wherein the first input (155) is coupled to the analog predistortion circuitry (151).

9. Amplifier device of any one of the claims 1 to 6, wherein the main signal path (13) comprises a frequency up-converter (163) having an output coupled to the amplifier input (141), wherein the signal predistortion circuitry (15) comprises a first input (155) coupled to the main signal path between the output of the frequency up-converter (163) and the amplifier input (141), wherein the first input (155) is coupled to the analog predistortion circuitry (151), optionally the first input is coupled to the digital predistortion circuitry (152).

10. Amplifier device of any one of the preceding claims, wherein the main signal path (13) comprises a signal splitter configured to split a signal in quadrature components (I, Q) having a quadrature phase relationship, wherein the signal predistortion circuitry (15) comprises a quadrature component input (755, 756) for each of the quadrature components, wherein the quadrature component inputs (755, 756) are coupled to the digital predistortion circuitry (752, 852), optionally wherein the quadrature component inputs (755, 756) are coupled to the analog predistortion circuitry (751).

11. Amplifier device of any one of the preceding claims, wherein the signal output (12) is configured to output an analog signal of radio frequency.

12. Apparatus (90), comprising an antenna (91, 92, 93) and driving circuitry (94) coupled to the antenna and configured to generate a magnetic field by the antenna, wherein the driving circuitry comprises the amplifier device (10, 10', 10") of any one of the preceding claims, particularly the antenna is an electromagnetic coil, more particularly the antenna is a magnetic resonance imaging coil.

13. Method of linearizing an output of an amplifier device, the method comprising:
generating (42, 43, 44), for an analog signal to be amplified (461), a first predistortion signal (421) for the analog signal by analog predistortion circuitry and a second predistortion signal (431) for the analog signal by digital predistortion circuitry,
adapting (45) the analog signal based on the first predistortion signal and on the second predistortion signal to obtain an adapted analog signal for at least partially compensating a non-linearity of an amplifier circuitry (14) of the amplifier device, and
amplifying (47) a power level of the adapted analog signal by the amplifier circuitry,
**characterised in that** the first predistortion signal (421) and the second predistortion signal (431) are generated in respective analog (420) and digital (430) signal paths which are parallel signal paths.

14. Method of the preceding claim, further comprising combining the first predistortion signal (421) and the second predistortion signal (431) to obtain a third predistortion signal (441) and wherein adapting (45) the analog signal comprises adapting the analog signal based on the third predistortion signal, preferably wherein adapting (45) the analog signal comprises amplifying the analog signal by a gain, wherein the third predistortion signal (441) defines a level of the gain.

15. Method of claim 13 or 14, further comprising:
frequency down-converting the analog signal from a first frequency to a second frequency,
applying the analog signal as an input to the analog predistortion circuitry at the first frequency, and
applying the analog signal as an input to the digital predistortion circuitry at the second frequency, preferably wherein the first frequency is a radio frequency.
